# EUROPEAN PATENT APPLICATION

(11) **EP 1 855 516 A1**
(43) Date of publication of application: **14.11.2007**
(21) Application number: 06715221.5
(22) Date of filing: 03.03.2006
(51) Int. Cl.: H05K 3/28, H01L 23/12, H05K 3/46

(54) **CERAMIC MULTILAYER BOARD AND METHOD FOR MANUFACTURING SAME**

(30) Priority: 04.03.2005 JP 2005060769
(71) Applicant: MURATA MANUFACTURING CO., LTD., Nagaokakyo-shi, Kyoto 617-8555 (JP)
(72) Inventor: KAWAKAMI, Hiromichi, otari 1-chome, Nagaokakyo-shi, Kyoto, 61 (JP); FUJITA, Iwao, otari 1-chome, Nagaokakyo-shi, Kyoto, 61 (JP); TOSE, Makoto, otari 1-chome, Nagaokakyo-shi, Kyoto, 61 (JP); SAITO, Yoshifumi, otari 1-chome, Nagaokakyo-shi, Kyoto, 61 (JP); KIMURA, Masahiro, otari 1-chome, Nagaokakyo-shi, Kyoto, 61 (JP)
(74) Representative: Schoppe, Fritz
(86) International application number: PCT/JP2006/304162
(87) International publication number: WO 2006/093293

(57) **Abstract**

A ceramic multilayer substrate which has excellent migration resistance and high bonding strength between a resin sealing material and a ceramic multilayer substrate body, and its manufacturing method are obtained.

The entire laminated substrate body (2) including lands (16) and (17), and external electrodes (24) and (25) is covered with a siloxane film formed by means of a PVD process. The thickness of the siloxane film is set less than 100 nm. After that, external electrodes (16) and (17) of a mounting component (11) are electrically connected and firmly hold to the lands (16) and (17) of the laminated substrate body 2 via solder (19). Next, a resin sealing material (4) for sealing the mounting component (11) is formed on the laminated substrate body (2).

## Description

### Technical Field

The present invention relates to a ceramic multilayer substrate, especially, to a ceramic multilayer substrate for mounting an electronic component such as an IC component on its surface, and its manufacturing method.

### Background Art

In general, in a ceramic multilayer substrate, Ag- or Cu- based lands for mounting a mounting component and further external electrodes for mounting the multilayer substrate itself are formed on the substrate surface. On the lands and the external electrodes, a solderable and wire-bondable plating film is formed. The plating film also has an effect of suppressing the migration of the lands and the external electrodes.

However, previously, when a ceramic multilayer substrate was used under a high electric field, since the plating film formed on the lands and the external electrodes did not sufficiently suppress the migration, the formation of a protective film made of glass or resin in addition to the plating film has been required. Consequently, there have been problems related to design constraints and the increase in the manufacturing cost, due to the formation of the protective film.

Moreover, as described in Patent Document 1, in order to protect the mounting component mounted on the ceramic multilayer substrate, in some cases, the mounting component is sealed with a resin sealing material. However, since the wettability between the resin sealing material and the ceramic multilayer substrate body is not good, there has also been a problem that the bonding strength between the resin sealing material and the ceramic multilayer substrate body is not sufficient.

In addition, as for the technologies for forming a siloxane film by means of sputtering, they are described in Patent Document 2 and Patent Document 3.
Patent Document 1: Japanese Unexamined Patent Application Publication No. 2003-249840
Patent Document 2: Japanese Unexamined Patent Application Publication No. 06-152109
Patent Document 3: Japanese Unexamined Patent Application Publication No. 08-213742

### Disclosure of Invention

Consequently, the object of the present invention is to provide a ceramic multilayer substrate that has excellent migration resistance and high bonding strength between the resin sealing material and the ceramic multilayer substrate body, and its manufacturing method.

In order to achieve the above-mentioned object, the ceramic multilayer substrate according to a first invention characterized in including a laminated substrate body constituted by stacking a plurality of ceramic layers and inner conductor layers, lands provided on the surface of the laminated substrate body for being electrically connected to the external electrodes of the mounting component; and a siloxane film provided so as to cover the laminated substrate body and the land, and having a thickness less than 100 nm.

As for the ceramic multilayer substrate according to the first invention, further, it is preferable for the siloxane film to be provided so as to cover the mounting component mounted on the lands via solder and at least a par of the solder.

The ceramic multilayer substrate according to a second invention characterized in including a laminated substrate body constituted by stacking a plurality of ceramic layers and inner conductor layers; lands provided on the surface of the laminated substrate body for being electrically connected to the external electrodes of the mounting component; a mounting component mounted on the lands via solder; and a siloxane film provided so as to cover the laminated substrate body, the mounting component, and at least a part of the solder, and having a thickness less than 100 nm.

As for the ceramic multilayer substrates according to the first and second inventions, further they are preferable to include a resin sealing material for sealing the mounting component. Further, it is preferable for the resin sealing material to be covered with a siloxane film.

The ceramic multilayer substrate according to a third invention characterized in including a laminated substrate body constituted by stacking a plurality of ceramic layers and inner conductor layers; lands provided on the surface of the laminated substrate body for being electrically connected to the external electrodes of the mounting component; the mounting component mounted on the lands via solder; a resin sealing material for sealing the mounting component; and a siloxane film provided so as to cover the laminated substrate body and the resin sealing material, and having a thickness less than 100 nm.

In the ceramic multilayer substrates according to the first to third inventions, it is preferable for the mounting component to include an IC component and to be electrically connected to the lands by means of wire bonding. The IC component may be contained in a cavity provided on one principal surface of the laminated substrate body. Moreover, a plating film may also be formed on the lands.

The manufacturing method of a ceramic multilayer substrate according to a fourth invention characterized in including steps of constituting a laminated substrate body by stacking a plurality of ceramic layers and inner conductor layers; forming lands on the surface of the laminated substrate body to be electrically connected to the external electrodes of a mounting component; and forming a siloxane film with a thickness less than 100 nm so as to cover the laminated substrate body and the lands by means of a PVD process.

As for the manufacturing method of a ceramic multilayer substrate according to the fourth invention, further they may include steps of mounting a mounting component on the lands on which the siloxane film is formed, via solder; and forming a siloxane film with a thickness less than 100 nm so as to cover the mounting component and at least a part of the solder by means of a PVD process.

The manufacturing method of a ceramic multilayer substrate according to a fifth invention characterized in including steps of constituting a laminated substrate body by stacking a plurality of ceramic layers and inner conductor layers; forming lands to be electrically connected to the external electrodes of a mounting component on the surface of the laminated substrate body; mounting the mounting component on the lands via solder; and forming a siloxane film with a thickness less than 100 nm so as to cover the mounting component and at least a part of the solder by means of a PVD process.

As for the manufacturing methods of a ceramic multilayer substrate according to the fourth and fifth inventions, they may include a step of sealing the mounting component with a resin sealing material subsequent to the step of forming the siloxane film so as to cover the mounting component by means of the PVD process. Further they may include a step of forming a siloxane film with a thickness less than 100 nm so as to cover the resin sealing material 1 by means of the PVD process.

The manufacturing method of a ceramic multilayer substrate according to a sixth invention characterized in including steps of constituting a laminated substrate body by stacking a plurality of ceramic layers and inner conductor layers; forming lands to be electrically connected to the external electrodes of a mounting component on the surface of the laminated substrate body; mounting the mounting component, on the lands via solder; sealing the mounting component with a resin sealing material; and forming a siloxane film with a thickness less than 100 nm so as to cover the laminated substrate body and the resin sealing material by means of a PVD process.

The manufacturing method of a ceramic multilayer substrate according to a seventh invention characterized in including steps of constituting a laminated substrate body by stacking a plurality of ceramic layers and inner conductor layers; forming lands to be electrically connected to the external electrodes of a mounting component, on the surface of the laminated substrate body; forming solder balls on the lands; forming a siloxane film with a thickness below 100 nm so as to cover the lands and the solder balls by means of a PVD process; forming a siloxane film with a thickness less than 100 nm so as to cover the mounting component by means of a PVD process; and mounting the mounting component on the lands via solder balls.

The manufacturing method of a ceramic multilayer substrate according to an eighth invention characterized in including steps of constituting a laminated substrate body by superposing a plurality of ceramic layers and inner conductor layers; forming lands to be electrically connected to the external electrodes of a mounting component, on the surface of the laminated substrate body; forming solder balls on the lands; forming a siloxane film with a thickness less than 100 nm so as to cover the laminated substrate body and the lands by means of a PVD process; forming solder balls on the mounting component; forming a siloxane film with a thickness less than 100 nm so as to cover the mounting component and the solder balls by means of a PVD process; and mounting the mounting component on the lands via solder balls.

As for the manufacturing methods of a ceramic multilayer substrate according to the seventh and eighth inventions, they may include a step of sealing the mounting component with a resin sealing material subsequent to the step of mounting the mounting component. Further they may include a step of forming a siloxane film with a thickness less than 100 nm so as to cover the laminated substrate body and the resin sealing material by means of the PVD process.

As for the manufacturing methods of a ceramic multilayer substrate according to the fourth to eighth inventions, they preferably include a step of activating the surface of the siloxane film. The step of activating the siloxane film preferably performed by subjecting the surface of the siloxane film to cleaning using oxygen plasma. Advantages of the Invention

According to the present invention, since a siloxane film with a thickness less than 100 nm is provided so as to cover a laminated substrate body and lands, by a water repellent effect, the migration resistance can be improved, and chemical environmental characteristics such as sulfuration and oxidation, is also improved. Further, since the thickness of the siloxane film is less than 100 nm, soldering and wire bonding can be performed without problems.

If both of the laminated substrate body and the mounting component mounted via solder are covered with a siloxane film, the siloxane film covers the exposed portion of the solder, thereby, enabling to suppress flushing out of the solder.

Moreover, when a resin sealing material for sealing the mounting component is included, the wettability between the resin sealing material and the siloxane film is good, and the bonding strength between the siloxane film and the laminated substrate body is also high, thereby, enabling to enhance the bonding strength between the resin sealing material and the laminated substrate body.

If the resin sealing material is provided so as to cover the siloxane film, the moisture absorption of the resin sealing material is suppressed, thereby, enabling to suppress the change of the characteristics of the mounting component due to the moisture absorbed by the resin sealing material, or impurities occurred by hydrolysis of the resin sealing material.

Moreover, if the laminated substrate body and the resin sealing material are simultaneously covered with a siloxane film, the sides of the interface between the laminated substrate body and the resin sealing material are covered with the siloxane film, thereby, enabling to suppress peeling of the interface between the laminated substrate body and the resin sealing material.

If a mounting component is mounted on the substrate body via solder balls covered with the siloxane film, the flushing out of the solder can be further surely suppressed.

### Brief Description of the Drawings

[Fig. 1] Fig. 1 is a sectional view showing a first embodiment of a ceramic multilayer substrate according to the present invention.
[Fig. 2] Fig. 2 is an illustrative view showing the step of forming a siloxane film.
[Fig. 3] Fig. 3 is a graph showing the relationship between the quantity of silicone based resin and the thickness of the siloxane film.
[Fig. 4] Fig. 4 is a graph showing the relationship between the quantity of silicone based resin and the area of wetting.
[Fig. 5] Fig. 5 is a sectional view showing a modified embodiment of a first embodiment of a ceramic multilayer substrate according to the present invention.
[Fig. 6] Fig. 6 is a sectional view showing a second embodiment of a ceramic multilayer substrate according to the present invention.
[Fig. 7] Fig. 7 is a sectional view showing a third embodiment of a ceramic multilayer substrate according to the present invention.
[Fig. 8] Fig. 8 is a sectional view showing a fourth embodiment of a ceramic multilayer substrate according to the present invention.
[Fig. 9] Fig. 9 is a sectional view showing a fifth embodiment of a ceramic multilayer substrate according to the present invention.
[Fig. 10] Fig. 10 is a sectional view showing a modified embodiment of a fifth embodiment of a ceramic multilayer substrate according to the present invention.
[Fig. 11] Fig. 11 is a sectional view showing another modified embodiment of the fifth embodiment 5 of a ceramic multilayer substrate according to the present invention.
[Fig. 12] Fig. 12 is a sectional view showing a sixth embodiment 6 of a ceramic multilayer substrate according to the present invention.
[Fig. 13] Fig. 13 is a sectional view showing a seventh embodiment 7 of a ceramic multilayer substrate according to the present invention.
[Fig. 14] Fig. 14 is a sectional view showing an eighth embodiment of a ceramic multilayer substrate according to the present invention.
[Fig. 15] Fig. 15 is a sectional view showing a ninth embodiment of a ceramic multilayer substrate according to the present invention.

### Best Mode for Carrying Out the Invention

Hereinafter, referring to the appended drawings, embodiments of a ceramic multilayer substrate and its manufacturing method according to the present invention will be described.

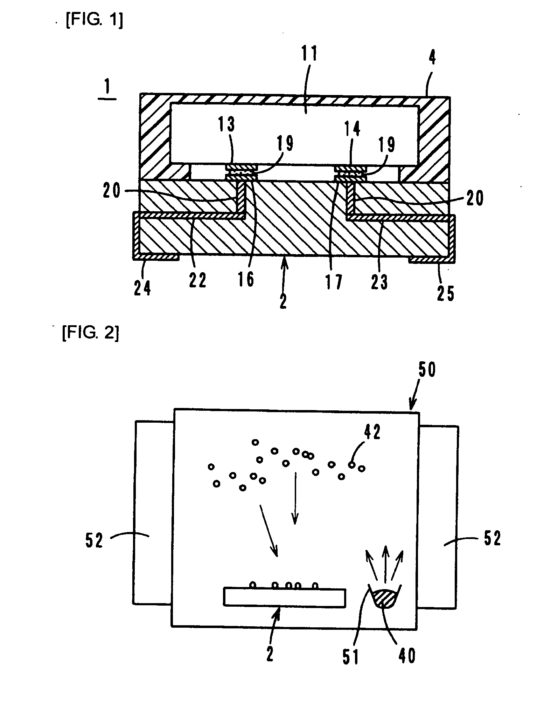

### FIRST EMBODIMENT (see Figs. 1 to 4)

The ceramic multilayer substrate 1 shown in Fig. 1, is substantially constituted by a laminated substrate body 2, a mounting component (IC component) 11 mounted on the laminated substrate body 2, and a resin sealing material 4 for sealing the mounting component 11.

Lands 16 and 17 are formed on the upper surface of the laminated substrate body 2. The mounting component 11, whose external electrodes 13 and 14 provided on its bottom surface are connected to the lands 16 and 17 via solder 19, is mounted on the laminated substrate body 2.

In the inside of the laminated substrate body 2, inner conductor patterns 22 and 23 are formed. One end of the inner conductor pattern 22 and one end of the inner conductor pattern 23 are electrically connected to lands 16 and 17, respectively, via via-hole conductors 20 formed in the laminated substrate body 2. The other ends of the inner conductor patterns 22 and 23 are electrically connected to external electrodes 24 and 25, respectively, reaching from the sides to the bottom surface of the laminated substrate body 2.

The laminated substrate body 2 is manufactured by the following manufacturing procedures. First, crystallized glass powder made of SiO₂, Al₂O₃, B₂O₃, and CaO, and alumina powder are blended at an equal weight ratio. By adding polyvinyl-butyral of 15 parts by weight, isopropyl-alcohol of 40 parts by weight, and trole of 20 parts by weight to the blended powder of 100 parts by weight, and blending them in a ball mill for 24 hours, a slurry is made. By shaping the slurry to a sheet with a thickness of 120 µm by means of a doctor blade process, a ceramic green sheet is obtained.

Next, holes for via-holes are formed in predetermined ceramic green sheets. Subsequently, conductive paste is filled in the holes for via-holes to form via-hole conductors 20, and inner conductor patterns 22 and 23 are formed on each ceramic green sheet by means of a screen printing process. Additionally, the via-hole conductors 20 may be formed by filling a conductive paste in holes for via-holes at the same time when the inner conductor patterns 22 and 23 are formed on each ceramic green sheet by means of the screen printing process.

After being stacked, the ceramic green sheets are contact bonded at a pressure of 50 MPa, and at a temperature of 60°C to form a laminated block. After the laminated block is cut into pieces having a predetermined size, the pieces are sintered in a lump. In this manner, they are made as low-temperature sintered ceramic laminated substrate bodies 2.

Next, by coating conductive paste on the surface of the laminated substrate body 2, and subsequent baking thereof, lands 16 and 17, and external electrodes 24 and 25 are formed. Further, by subjecting the lands 16 and 17, and the external electrodes 24 and 25 to Ni-Au plating, a plating film is formed.

Next, as shown in Fig. 2, silicone based resin 40 contained in a crucible 51 and the laminated substrate body 2 are placed together in an oven 50 to be sealed, and heated by a heater 52. At this time, siloxane 42 that is a constituent of the silicone based resin 40 is vaporized to be deposited on the surface of the laminated substrate body 2. In this manner, the entire laminated substrate body 2 including the lands 16 and 17, and the external electrodes 24 and 25, is covered with a siloxane PVD (Physical Vapor Deposition) protective film. The thickness of the siloxane PVD protective film (hereinafter referred to as siloxane film) is set less than 100 nm. In Fig. 1, the siloxane film is not shown.

As the siloxane film is formed by means of a PVD process, rather than a CVD (Chemical Vapor Deposition) process or a plasma process, since only heating the siloxane film together with the silicone-based resin 40 is required, the siloxane film can be formed easily and at a low price.

The curing conditions for the silicone based resin 40 are, for example, 150°C for 2 hours. When the silicone-based resin 40 is cured, its constituent siloxane 42 is vaporized, the concentration of the siloxane in the oven 50 becomes highest at 150°C, and together with the vaporization, deposition on the surface of the laminated substrate body 2 also occurs. After the silicone-based resin 40 is cured, when the temperature within the oven 50 is lowered, the siloxane 42 is further deposited on the surface of the laminated substrate body 2, as its saturated vaporization pressure becomes smaller.

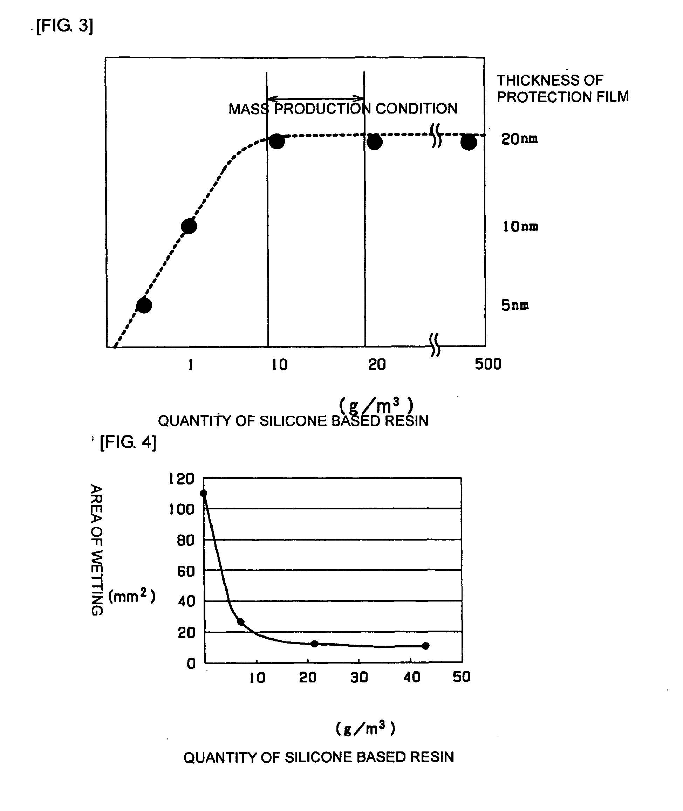

Fig. 3 is a graph showing the relationship between the quantity of the silicone-based resin 40 placed in the oven 50 and the thickness of the siloxane film formed on the laminated substrate body 2. If the silicone-based resin 40 in the oven 50 is less than 10 g/m³, by changing the quantity of the silicone-based resin 40, the film thickness of the siloxane film can be adjusted. If the silicone-based resin 40 in the oven 50 is 10 g/m³ or more, the film thickness becomes a constant value of about 20 nm. This is because the concentration of the siloxane in the oven 50 is saturated.

Items as shown in Table 1 were evaluated with respect to a laminated substrate body 2 thus produced. For comparison, a laminated substrate body on which a siloxane film was not formed, was also evaluated. The occurrence of migration was evaluated under testing conditions of 85°C, 85% RH, and 50VDC. Sulfuration was evaluated by standing the substrate bodies 2 in an atmosphere of hydrogen sulfide for one minute. Solder wettability was determined as acceptable when 95% or more of a square land of 2 mm x 2 mm dipped with Sn-Pb solder was wet with solder. Wire bondability was determined as acceptable when a square land of 2 mm x 2 mm bonded to a wire and had a bonding strength of 2 gf or more.

**Table 1**

| Siloxane PVD protective film | present | not present |
|---|---|---|
| Occurrence of migration | none | occurred |
| Evaluation of sulfuration | acceptable | silver sulfide precipitated on the edge part |
| Solder wettability | acceptable | acceptable |
| Wire bondability | min:3.9 gf | min:4.0 gf |

As is clear from Table 1, since the siloxane film covers the entire laminated substrate body 2 including lands 16 and 17, and external electrodes 24 and 25, the migration resistance is improved markedly. This is due to the water repellent effect of the siloxane film. Fig. 4 is a graph showing the relationship between the quantity of the silicone based resin 40 placed in the oven 50 and the wetted area of the laminated substrate body 2.

Further, environmental characteristics such as sulfuration and oxidization are also improved. Since the siloxane film is formed by means of a PVD process, the siloxane film is formed inside micro-level defects, thus, even migration or sulfuration originating from micro defects can also be suppressed.

Meanwhile, since the thickness of the siloxane film is as thin as less than 100 nm, the levels of mountability of solder wettability and wire bondability of the lands 16 and 17 and the external electrodes 24 and 25, are accceptable.

Next, the surface of the siloxane film covering the laminated substrate body 2 is activated by cleaning by means of a process such as plasma (preferably oxygen plasma) irradiation or ultra-violet irradiation. This enables further improvement in the wettability with respect to the resin sealing material 4. After that, the external electrodes 13 and 14 of the mounting component 11 are electrically connected and firmly fixed to the lands 16 and 17 of the laminated substrate body 2 via solder 19.

Next, the resin sealing material 4 for sealing the mounting component 11 is formed on the laminated substrate body 2. As for the material of the resin sealing material 4, a thermosetting resin such as an epoxy-based resin, or a photosensitive resin is desirable. Since the resin sealing material 4 has a good wettability with respect to the siloxane film, and the bonding strength between the silicone thin film and the laminated substrate body 2 is also high, the bonding strength between the resin sealing material 4 and the laminated substrate body 2 can be enhanced.

In addition, soldering of the mounting component 11 may be performed either before or after the formation of the siloxane film. Table 2 is a table showing evaluated results of the ceramic multilayer substrate when soldering of the mounting component 11 is performed before and after the formation of the siloxane film.

In other words, sample 1 is a ceramic multilayer substrate where, after the mounting component 11 is soldered to the laminated substrate body 2, the siloxane film is formed on the laminated substrate body 2, which is sealed with the resin sealing material 4. Sample 2 a ceramic multilayer substrate where, after the siloxane film is covered the laminated substrate body 2, the mounting component 11 is soldered to the laminated substrate body 2, which is sealed with the resin sealing material 4. For comparison, sample 3 is a ceramic multilayer substrate where, without forming the siloxane film on the laminated substrate body 2, the mounting component 11 is soldered to the laminated substrate body 2, which is sealed with the resin sealing material 4.

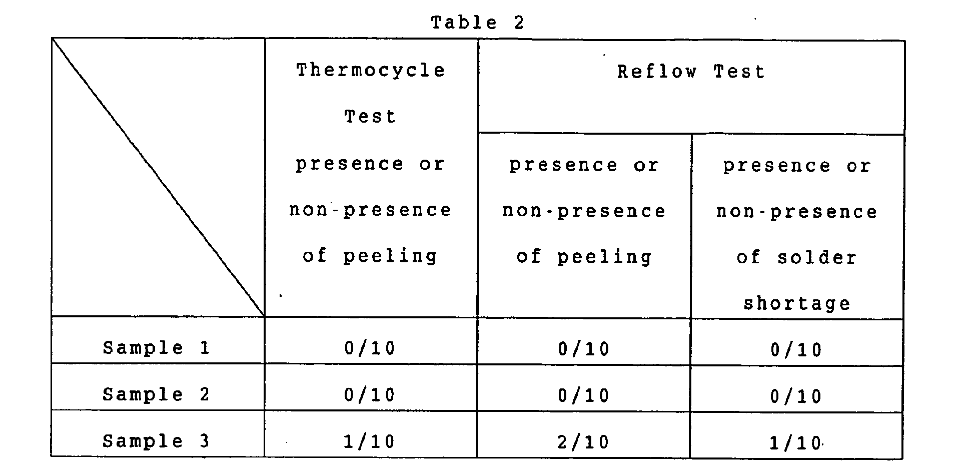

The thermo cycle test was performed for 400 cycles at - 55°C/+125°C, and the state of peeling between the resin sealing material 4 and the laminated substrate body 2 was confirmed at the sides and at the cross section. The solder reflow test after moisture absorption was performed by standing samples for 40 hours under the conditions of 60°C and 60%RH, and subsequently, reflowing the samples at 260°C five times, and the state of peeling between the resin sealing material 4 and the laminated substrate body 2 was confirmed at the sides and at the cross section, and solder shortage was confirmed.

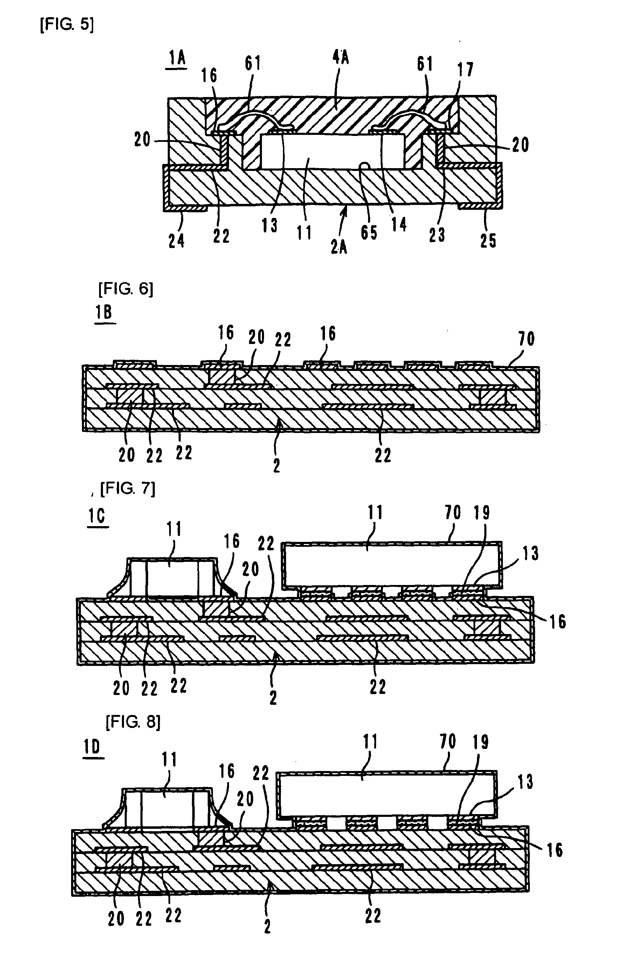

### MODIFICATION OF FIRST EMBODIMENT (see Fig. 5)

Moreover, the ceramic multilayer substrate 1A shown in Fig. 5, is substantially constituted by a laminated substrate body 2A, a mounting component 11 contained in a cavity 65 provided on the laminated substrate body 2A, and a resin sealing material 4A for sealing the mounting component 11.

On the upper side of steps in the cavity 65 of the laminated substrate body 2A, lands 16 and 17 are formed. The mounting component 11 is disposed in the cavity 65, and its external electrodes 13 and 14 are electrically connected to the lands 16 and 17 by wire bonding 61.

In the inside of the laminated substrate body 2A, internal electrode patterns 22 and 23 are formed. One end of the internal electrode pattern 22 and one end of the internal electrode pattern 23 are electrically connected to the lands 16 and 17, respectively, via via-hole conductors 20 formed in the laminated substrate body 2A. The other ends of the internal electrode patterns 22 and 23 are electrically connected to external electrodes 24 and 24, respectively.

On the lands 16 and 17 and on the external electrodes 24 and 25, a Ni-Au plating film is formed. Further, the entire laminated substrate body 2A including the lands 16 and 17 and the external electrodes 24 and 25 is covered with a siloxane film. The thickness of the siloxane film is set less than 100 nm. In Fig. 5, the siloxane film is not shown.

Further, a resin sealing material 4A for sealing the mounting component 11 is filled in the cavity 65 of the laminated substrate body 2A. As for the material of the resin sealing material 4A, a thermosetting resin such as an epoxy-based resin, or a photosensitive resin is desirable.

In the ceramic multilayer substrate 1A composed of the above-mentioned configuration, since the siloxane film covers the entire laminated substrate body 2A including the lands 16 and 17 and the external electrodes 24 and 25, the migration property is improved markedly. Meanwhile, since the thickness of the siloxane film is as thin as less than 100 nm, the levels of mountability of solder wettability and wire bondability of the lands 16 and 17 and the external electrodes 24 and 25 of the lands 16 and 17 and the external electrodes 24 and 25, are accceptable. The wire bonding may be performed either before or after the formation of the siloxane film. Moreover, since the resin sealing material 4A has a good wettability with respect to the siloxane film, and the bonding strength between the siloxane film and the laminated substrate body 2A is also high, the bonding strength between the resin sealing material 4 and the laminated substrate body 2A can be enhanced.

### SECOND EMBODIMENT (see Fig. 6)

Next, a second embodiment of a ceramic multilayer substrate according to the present invention and its manufacturing method will be described. The ceramic multilayer substrate 1B shown in Fig. 6, is constituted by a laminated substrate body 2, lands 16 formed on the upper surface of the laminated substrate body 2, and a siloxane film 70 provided so as to cover the laminated substrate body 2 and the lands 16. In the inside of the laminated substrate body 2, via-holes 20 for connecting between a conductive pattern 22 formed at an interface between layers and another conductive pattern 22 formed at another interface between layers, or the land 16, are formed.

The laminated substrate body 2 is manufactured by the following manufacturing procedures. First, crystallized glass powder made of SiO₂, Al₂O₃, B₂O₃, and CaO, and alumina powder are blended at an equal weight ratio. By adding polyvinyl-butyral of 15 parts by weight, isopropyl-alcohol of 40 parts by weight, and trole of 20 parts by weight to the blended powder of 100 parts by weight, and blending them in a ball mill for 24 hours, a slurry is made. By shaping the slurry to a sheet with a thickness of 120 µm by means of a doctor blade process, a ceramic green sheet is obtained.

Next, holes for via-holes are formed in predetermined ceramic green sheets. Subsequently, conductive paste is filled in the holes for via-holes to form via-hole conductors 20, and inner conductor patterns 22 are formed on eac.h ceramic green sheet by means of a screen printing process. Additionally, the via-hole conductors 20 may be formed by filling a conductive paste in holes for via-holes at the same time when the inner conductor patterns 22 are formed on each ceramic green sheet by means of the screen printing process.

After being stacked, the ceramic green sheets are contact bonded at a pressure of 50 MPa, and at a temperature of 60°C to form a laminated block. After the laminated block is cut into pieces having a predetermined size, the pieces are sintered in a lump. In this manner, they are made as low-temperature sintered ceramic laminated substrate bodies 2.

Next, by coating conductive paste on the surface of the laminated substrate body 2, and subsequent baking thereof, lands 16 are formed. In addition, the lands 16 may be formed by forming a land pattern on a ceramic green sheet, and by sintering the land pattern and the ceramic green sheet, simultaneously. Further, a plating film may be formed by subjecting the lands 16 to Ni-Au plating. In addition, the plating film may not be formed.

Next, by means of a method similar to that of the above-mentioned first embodiment, a ceramic multilayer substrate 1B is produced by forming a siloxane film 70 with a thickness less than 100 nm on the laminated substrate body 2 so as to cover the laminated substrate body 2 and the lands 16. In addition, in Fig. 6, although the whole surface of the laminated substrate body 2 is covered with the siloxane film, at least the principal surface on which the lands 16 are formed, should be covered, for example, the bottom surface may not be covered.

In the ceramic multilayer substrate 1B composed of the above-mentioned configuration, since the siloxane film 70 covers the entire laminated substrate body 2 including the lands 16, the migration resistance can be improved markedly, and environmental characteristics such as sulfuration and oxidization are also improved. Meanwhile, since the thickness of the siloxane film 70 is as thin as less than 100 nm, the levels of mountability of solder wettability and wire bondability of the lands 16, are acceptable.

### THIRD EMBODIMENT (see Fig. 7)

Next, a third embodiment of a ceramic multilayer substrate according to the present invention and its manufacturing method will be described. The ceramic multilayer substrate 1C shown in Fig. 7, is substantially constituted by a laminated substrate body 2, mounting components 11 mounted on the laminated substrate body 2, and a siloxane film 70 provided so as to cover the laminated substrate body 2 and the mounting components 11.

On the upper surface of the laminated substrate body 2, lands 16 are formed. The mounting component 11, whose external electrodes provided on its bottom surface are bonded to the lands 16 via solder 19, is mounted on the laminated substrate body 2. At least a part of such a part of the lands 16 that is not contacted to the solder 19 and exposed, is covered with the siloxane film 70. At least a part of the part of the solder 19 which is exposed and not contacted to the lands 16 and the external electrodes 13, is covered with the siloxane film 70. In the inside of the laminated substrate body 2, via-holes 20 for connecting between a conductive pattern 22 formed at an interface between layers and another conductive pattern 22 formed at another interface between layers, or the land 16, are formed. In addition, in Fig. 7, as for the mounting component 11, whose external electrodes 13 are formed on its bottom surface, of the mounting components 11, on the sides of the external electrodes 13 formed on the center of the mounting component 11 and on the sides of the solder 19 connected to the external electrodes 13, the siloxane film 70 is not formed, however, the siloxane film 70 may be formed on these parts.

The ceramic multilayer substrate 1C is manufactured by the following procedures. The laminated substrate body 2 is formed by means of a method similar to that of the above-mentioned second embodiment. Next, by means of a method similar to that of the above-mentioned first embodiment, a siloxane film 70 with a thickness less than 100 nm is formed. Next, the mounting components 11 are mounted on the lands 16 on which the siloxane film 70 is formed, via the solder 19. After that, by means of the method similar to that of the above-mentioned first embodiment, the siloxane film 70 is formed again so as to cover the mounting components 11 and at a least part of such a part of the solder 19 that is not contacted to the lands 16 and the external electrodes 13, and exposed. In addition, at that time, the siloxane film 70 may be formed further on the laminated substrate body 2.

In the ceramic multilayer substrate 1C composed of the above-mentioned configuration, since the siloxane film 70 covers the entire laminated substrate body 2 including the lands 16, the migration resistance can be improved markedly, and environmental characteristics such as sulfuration and oxidization are also improved. Moreover, since the mounting components 11 are also covered with the siloxane film 70, chemical envioronmental characteristics such as sulfuration or oxidation of the mounting components 11 is also improved. Meanwhile, since the thickness of the siloxane film 70 is as thin as less than 100 nm, the levels of mountability of solder wettability and wire bondability of the lands 16, are acceptable. Further, since the siloxane film 70 covers at least a part of the solder 19, in a reflow step when the ceramic multilayer substrate 1C is mounted on the other substrate, flushing out of the solder 19 is suppressed. FOURTH EMBODIMENT (see Fig. 8)

Next, a fourth embodiment of a ceramic multilayer substrate according to the present invention and its manufacturing method will be described. The ceramic multilayer substrate 1D shown in Fig. 8, is substantially constituted by a laminated substrate body 2, mounting components 11 mounted on the laminated substrate body 2, and a siloxane film 70 provided so as to cover the laminated substrate body 2 and the mounting components 11.

On the upper surface of the laminated substrate body 2, lands 16 are formed. The mounting component 11, whose external electrodes 13 provided on its bottom surface are connected to the lands 16 via solder 19, is mounted on the laminated substrate body 2. At least a part of the lands 16 which is exposed and not contacted to the solder 19, is covered with the siloxane film 70. Moreover, at least a part of such a part of the solder 19 that is not contacted to the lands 16 and the external electrodes 13, and exposed, is covered with the siloxane film 70.

In the inside of the laminated substrate body 2, via-holes 20 for connecting between a conductive pattern 22 formed at an interface between layers and another conductive pattern 22 formed at another interface between layers, or the land 16, are formed. In addition, in Fig. 8, as for the mounting component 11, whose external electrodes 13 are formed on its bottom surface, of the mounting components 11, on the sides of the external electrodes 13 formed on the center of the mounting component 11 and on the sides of the solder 19 and lands 16 connected to the external electrodes 13, the siloxane film 70 is not formed, however, the siloxane film 70 may be formed on these parts.

The ceramic multilayer substrate 1D is manufactured by the following procedures. The laminated substrate body 2 is formed by means of a method similar to that of the above-mentioned second embodiment. Next, the mounting components 11 are mounted on the lands 16 via the solder 19. After that, by means of the method similar to that of the above-mentioned first embodiment, the siloxane film 70 is formed again so as to cover the mounting components 11 and at a least part of such a part of the solder 19 that is not contacted to the lands 16 and the external electrodes 13, and exposed.

In the ceramic multilayer substrate 1D composed of the above-mentioned configuration, since the siloxane film 70 covers the laminated substrate body 2 mounting components 11, ant at least a part of the lands 16, the migration resistance can be improved markedly, and environmental characteristics such as sulfuration and oxidization are also improved. Moreover, since the mounting components 11 are also covered with the siloxane film 70, chemical envioronmental characteristics such as sulfuration or oxidation of the mounting components 11 is also improved. Moreover, since the siloxane film 70 covers at least a part of the solder 19, in a reflow step when the ceramic multilayer substrate 1D is mounted on the other substrate, flushing out of the solder 19 is suppressed.

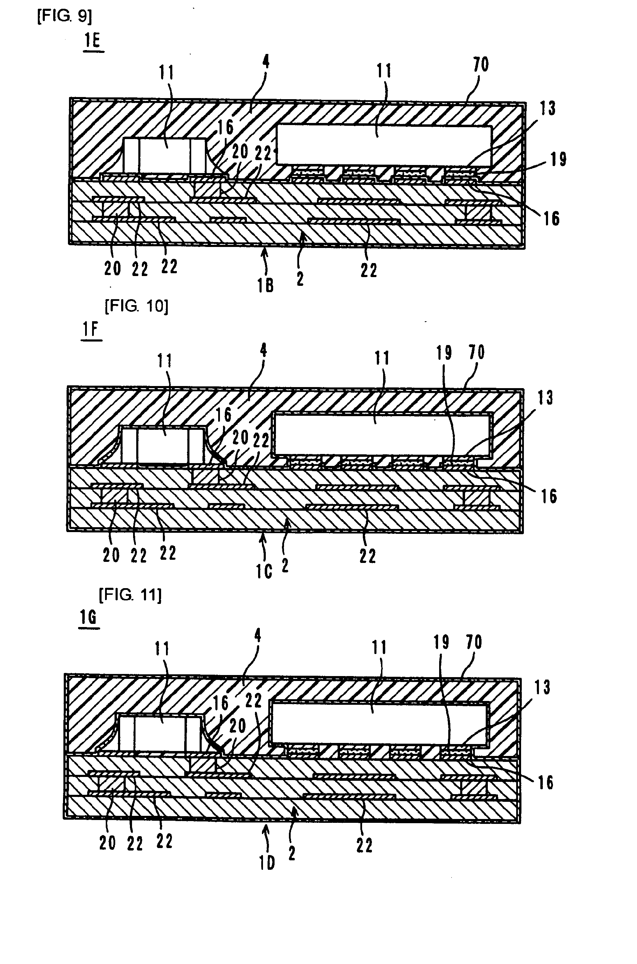

### FIFTH EMBODIMENT (see Fig. 9)

Next, a fifth embidiment of a ceramic multilayer substrate according to the present invention and its manufacturing method will be described. The ceramic multilayer substrate IE shown in Fig. 9, is constituted by a laminated substrate body 1B (see the second embodiment and Fig. 6), mounting components 11 mounted on the laminated substrate body 1B, a resin sealing material 4 for sealing the mounting components, and a siloxane film 70 provided so as to cover the resin sealing material 4.

On the upper surface of the ceramic multilayer substrate 1B, lands 16 covered with the siloxane film 70 are formed. The mounting component 11, whose external electrodes 13 provided on its bottom surface is bonded to the lands 16 via solder 19, is mounted on a laminated substrate body 2.

The ceramic multilayer substrate 1E is manufactured by the following procedures. The surface of the siloxane film 70 covering the ceramic multilayer substrate 1B produced by means of a method similar to that of the above-mentioned second embodiment is activated by cleaning by means of a process such as plasma (preferably, oxygen plasma) irradiation or ultraviolet irradiation. Next, on the lands 16 of the ceramic multilayer substrate 1B, the mounting components 11 are mounted via the solder 19. Next a resin sealing material 4 for sealing the mounting components 11 is formed. As for the material of the resin sealing material 4, a material similar to that described in the first embodiment can be used. After that, by means of a method similar to that of the above-mentioned first embodiment, the siloxane film 70 is formed so as to cover the resin sealing material 4. In addition, at this time, the siloxane film 70 may be formed further on the laminated substrate body 2. In Fig. 9, although the siloxane film 70 is formed on the resin sealing material 4, rather, the siloxane film 70 may not be formed so as to cover the resin sealing material 4.

### MODIFICATION OF FIFTH EMBODIMENT (see Figs. 10 and 11)

Similarly, as for ceramic multilayer substrates 1F and 1G, shown in Figs. 10 and 11, they respectively include the ceramic multilayer substrate 1C (see the third embodiment and Fig. 7) and the resin sealing material 4 on which a siloxane film 70 is formed, and the ceramic multilayer substrate 1D (see the fourth embodiment and Fig. 8) and the resin sealing material 4 on which a siloxane film 70 is formed. The methods for forming the resin sealing material 4 and the siloxane film 70 are similar to those of in the first embodiment. Although, in Figs. 10 and 11, the siloxane film 70 is formed on the resin sealing material 4, rather, the siloxane film 70 may not be formed so as to cover the resin sealing material 4.

In the ceramic multilayer substrates 1E, 1F, and 1G composed of the above-mentioned configurations, in addition to the effects of the ceramic multilayer substrates 1B, 1C, and 1D, the following effects can be obtained. Since the siloxane film 70 is formed on the interface between the resin sealing material 4 and the laminated substrate body 2, the bonding strength between the resin sealing material 4 and the laminated substrate body 2 can be enhanced. When the resin sealing material 4 is covered with the siloxane film 70, the moisture absorption of the resin sealing material 4 can be suppressed, thereby, enabling to suppress the change of the characteristics of the mounting components 11 due to the moisture absorbed by the resin sealing material 4, or impurities occurred by hydrolytic cleavage of the resin sealing material 4. Further, when the siloxane film 70 covers the sides of the interface between the resin sealing material 4 and the laminated substrate body 2, peeling of the interface between the laminated substrate body 2 and the resin sealing material 4 can be suppressed more surely.

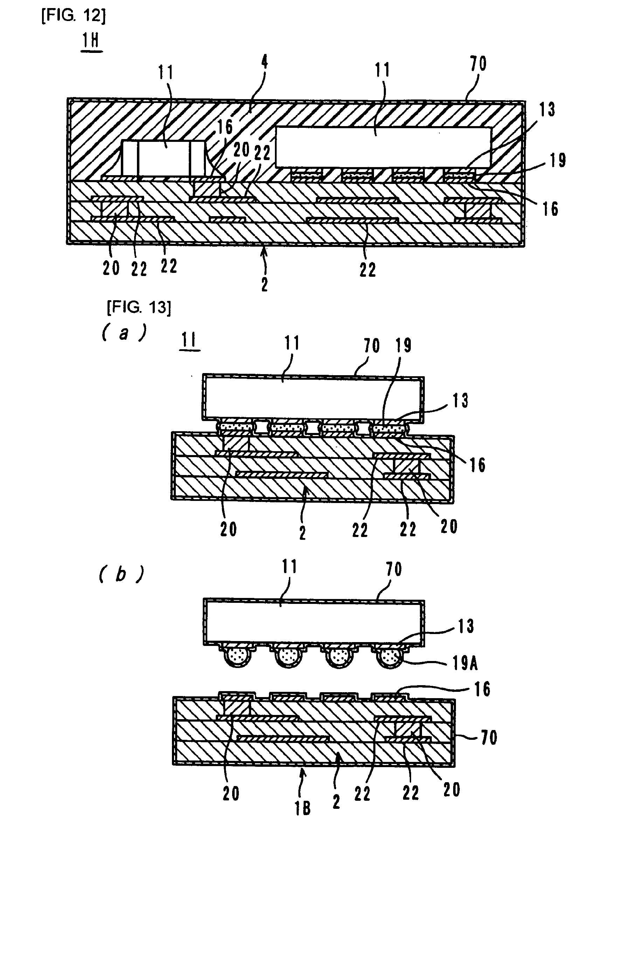

### SIXTH EMBODIMENT (see Fig. 12)

Next, a sixth embodiment of a ceramic multilayer substrate according to the present invention and its manufacturing method will be described. The ceramic multilayer substrate 1H shown in Fig. 12, is constituted by a laminated substrate body 2, mounting components 11 mounted on the laminated substrate body 2, a resin sealing material 4 for sealing the mounting components 11, and a siloxane film 70 provided so as to cover the laminated substrate body 2 and the resin sealing material 4.

On the upper surface of the laminated substrate body 2, lands 16 are formed. The mounting component 11, whose external electrodes 13 provided on its bottom surface is bonded to the lands 16 via solder 19, is mounted on the laminated substrate body 2.

The ceramic multilayer substrate 1H is manufactured by the following procedures. On the lands 16 of the ceramic multilayer substrate 2 produced by means of a method similar to that of the second embodiment, the mounting components 11 are mounted via the solder 19. Next, the resin sealing material 4 for sealing the mounting components 11 is formed. As for the material of the resin sealing material 4, a material similar to that described in the first embodiment can be used. After that, by means of a method similar to that of the first embodiment, the siloxane film is formed so as to cover the laminated substrate body 2 and the resin sealing material 4.

In the ceramic multilayer substrate 1H composed of the above-mentioned configuration, since the siloxane film 70 is covered with the siloxane film 70, the moisture absorption of the resin sealing material 4 can be suppressed, thereby, enabling to suppress the change of the characteristics of the mounting components 11 due to the moisture absorbed by the resin sealing material 4, or impurities occurred by hydrolytic cleavage of the resin sealing material 4. Further, since the siloxane film 70 covers the sides of the interface between the resin sealing material 4 and the laminated substrate body 2, peeling of the interface between the laminated substrate body 2 and the resin sealing material 4 can be suppressed more surely.

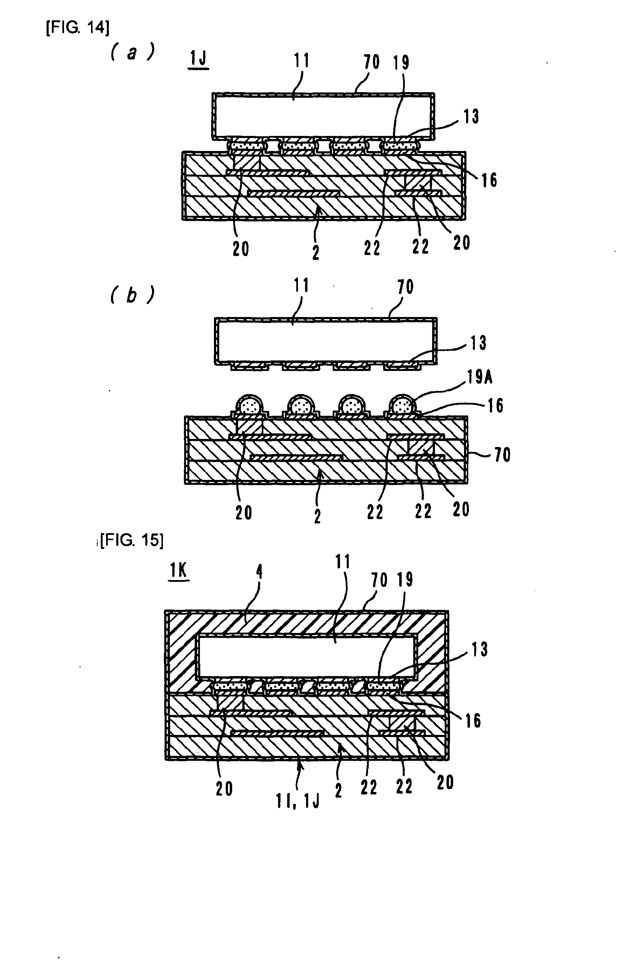

### SEVENTH EMBODIMENT (see Fig. 13)

Next, a seventh embodiment of a ceramic multilayer substrate according to the present invention and its manufacturing method will be described. The ceramic multilayer substrate 1I shown in Fig. 13(a), is constituted by a laminated substrate body 2, lands 16 formed on the upper side of the laminated substrate body 2, a mounting component 11 mounted on the lands 16 via solder 19, and a siloxane film 70 provided so as to cover the laminated substrate body 2 the mounting component 11 and at least a part of the solder 19. In the inside of the laminated substrate body 2, via-holes 20 for connecting between a conductive pattern 22 formed at an interface between layers and another conductive pattern 22 formed at another interface between layers, or the land 16, are formed.

The ceramic multilayer substrate 1I is manufactured by the following procedures. As shown in Fig. 13(b), first, by means of a method similar to that of the above-mentioned second embodiment, a ceramic multilayer substrate 1B, in which the laminated substrate body 2 and lands 1,6 formed on the upper surface of the laminated substrate body 2 are covered with the siloxane film 70, is produced. Meanwhile, solder balls 19A are formed on the external electrodes 13 of the mounting component 11, after that, the siloxane film 70 is formed so as to cover the mounting component 11 and the solder balls 19A. The siloxane film 70 is formed by means of a method similar to that of the above-mentioned first embodiment. Next, by arranging the mounting component 11 covered with the siloxane film 70 on the ceramic multilayer substrate 1B such that the solder balls 19A and the lands 16 correspond respectively, and subjecting the mounting component 11 to a heat treatment, the mounting component 11 is connected to the upper surface of the ceramic multilayer substrate 1B, thereby resulting in the production of the ceramic multilayer substrate 1l.

In the ceramic multilayer substrate 1I composed of the above-mentioned configuration since the siloxane film 70 covers the sides of the lands 16 that are not contacted to the solder 19 and the entire laminated substrate body 2, the migration resistance can be improved markedly, thereby, chemical environmental characteristics such as sulfuration or the oxidation is also improved. Moreover, since the mounting component 11 is also covered with the siloxane film 70, chemical environmental characteristics such as sulfuration or the oxidation of the mounting component 11, is also improved. Further, since all of the sides of the solder 19 which are not contacted to the lands 16 and the external electrodes 13 of the mounting component 11, are covered with the siloxane film 70, in a reflow step when the ceramic multilayer substrate 1I is mounted on the other substrate, flushing out of the solder 19 is surely suppressed. Meanwhile, since the thickness of the siloxane film is as thin as less than 100 nm, the siloxane film is caused to be moved due to the heat treatment in a soldering step, thereby, connectability via solder is acceptable. EIGHTH EMBODIMENT (see Fig. 14)

Next., an eighth embodiment of a ceramic multilayer Substrate according to the present invention and its manufacturing method will be described. The ceramic multilayer substrate 1J shown in Fig. 14(a), is constituted by a laminated substrate body 2, lands 16 formed on the upper side of the laminated substrate body 2, a mounting component 11 mounted on the lands 16 via solder 19, and a siloxane film 70 provided so as to cover the laminated substrate body 2 the mounting component 11 and at least a part of the solder 19. In the inside of the laminated substrate body 2, via-holes 20 for connecting between a conductive pattern 22 formed at an interface between layers and another conductive pattern 22 formed at another interface between layers, or the land 16, are formed.

The ceramic multilayer substrate 1J is manufactured by the following procedures. As shown in Fig. 14(b), first, solder balls 19A are formed on the lands 16 formed on the upper surface of the laminated substrate body 2. Next, the siloxane film 70 is formed so as to cover the laminated substrate body 2 and the solder balls 19A. Meanwhile, the siloxane film 70 is formed so as to cover the mounting component 11 and its external electrodes 13. The siloxane film 70 is formed by means of a method similar to that of the first embodiment. Next, by arranging the mounting component 11 covered with the siloxane film 70 on the ceramic multilayer substrate 1B such that the solder balls 19A and the lands 16 correspond respectively, and subjecting the mounting component 11 to a heat treatment, the mounting component 11 is connected to the upper surface of the laminated substrate body 2, thereby, resulting in the production of the ceramic multilayer substrate 1J.

In the ceramic multilayer substrate 1J composed of the above-mentioned configuration, since the siloxane film 70 covers the sides of the lands 16 that are not contacted to the solder 19 and the entire laminated substrate body 2, the migration resistance can be improved markedly, thereby, chemical environmental characteristics such as sulfuration or the oxidation is also improved. Moreover, since the mounting component 11 is also covered with the siloxane film 70, thereby, chemical environmental characteristics such as sulfuration or the oxidation of the mounting component 11 is also improved. Further, since all of the sides of the solder 19 which are not contacted to the lands 16 and the external electrodes 13 of the mounting component 11, are covered with the siloxane film 70, in a reflow step when the ceramic multilayer substrate 1J is mounted on the other substrate, flushing out of the solder 19 is surely suppressed. Meanwhile, since the thickness of the siloxane film is as thin as less than 100 nm, the siloxane film is caused to be moved due to the heat treatment in a soldering step, thereby, connectability via solder is acceptable. NINTH EMBODIMENT (see Fig. 15)

Next, a ninth embodiment of a ceramic multilayer substrate according to the present invention and its manufacturing method will be described. The ceramic multilayer substrate 1K shown in Fig. 15, is constituted by a laminated substrate body 1I (see the seventh embodiment and Fig. 13) or a laminated substrate body 1J (see the eighth embodiment and Fig. 14), a resin sealing material 4 for sealing the mounting component 11 on the ceramic multilayer substrate 1I or 1J, and a siloxane film 70 provided so as to cover the resin sealing material 4.

The ceramic multilayer substrate 1K is manufactured by the following procedures. The surface of the siloxane film 70 covering the ceramic multilayer substrate 1I or 1J produced by means of a method similar to that of the above-mentioned seventh and eighth embodiments, is activated by cleaning by means of a process such as plasma (preferably, oxygen plasma) irradiation or ultraviolet irradiation. Next, on the ceramic multilayer substrate 1I or 1J, the resin sealing material 4 for sealing the mounting component 11 is formed. As for the material of the resin sealing material 4, a material similar to that described in the first embodiment can be used. After that, by means of a method similar to that of the above-mentioned first embodiment, the siloxane film 70 is formed so as to cover the resin sealing material 4. In addition, at this time, the siloxane film 70 may be formed further on the laminated substrate body 2. In Fig. 15, although the siloxane film 70 is formed on the resin sealing material 4, rather, the siloxane film 70 may not be formed so as to cover the resin sealing material 4.

In the ceramic multilayer substrate 1K composed of the above-mentioned configuration, in addition to the effects of the ceramic multilayer substrates 1I and 1J, the following effects can be obtained. Since the siloxane film 70 is formed at the interface between the resin sealing material 4 and the laminated substrate body 2, the bonding strength between the resin sealing material 4 and the laminated substrate body 2 can be enhanced. When the resin sealing material 4 is covered with the siloxane film 70, the moisture absorption of the resin sealing material 4 can be suppressed, thereby, enabling to suppress the change of the characteristics of the mounting component 11 due to the moisture absorbed by the resin sealing material 4, or impurities occurred by hydrolytic cleavage of the resin sealing material 4. Further, when the siloxane film 70 covers the sides of the interface between the resin sealing material 4 and the laminated substrate body 2, peeling of the interface between the laminated substrate body 2 and the resin sealing material 4 can be suppressed more surely.

### ANOTHER EMBODIMENT

In addition, the ceramic multilayer substrates according to the present invention and its manufacturing methods are not intended to be limited to the above-mentioned embodiments, rather, they can be changed variously within the scope of the present invention.

For example, in the above-mentioned embodiments, embodiments where the laminated substrate body is formed by stacking ceramic green sheets, were shown, however, an embodiment where the laminated substrate body is formed by means of a method of alternately recoating ceramic paste and conductive paste, may be possible.

### Industrial Applicability

As above, the present invention is useful for a ceramic multilayer substrate for mounting an electronic component such as IC component on the surface thereof, and its manufacturing method, especially, it is excellent in that the migration resistance is good, and the bonding strength between a resin sealing material and a ceramic multilayer substrate body becomes higher.

## Claims

1. A ceramic multilayer substrate comprising:
a laminated substrate body constituted by stacking a plurality of ceramic layers and inner conductor layers;
a land provided on a surface of the laminated substrate body, for electrical connection to external electrodes of a mounting component; and
a siloxane film provided so as to cover the laminated substrate body and the land, the siloxane film having a thickness less than 100 nm.

2. The ceramic multilayer substrate according to claim 1, wherein the siloxane film is provided further so as to cover the mounting component mounted on the land via solder and at least a part of the solder.

3. A ceramic multilayer substrate comprising:
a laminated substrate body constituted by stacking a plurality of ceramic layers and inner conductor layers;
a land provided on a surface of the laminated substrate body, for electrical connection to external electrodes of a mounting component;
the mounting component mounted on the land via solder; and
a siloxane film provided so as to cover the laminated substrate body, the mounting component, and at least a part of the solder, and the siloxane film having a thickness less than 100 nm.

4. The ceramic multilayer substrate according to any one of claims 1 to 3, further comprising a resin sealing material for sealing the mounting component.

5. The ceramic multilayer substrate according to claim 4, wherein the resin sealing material is covered with the siloxane film.

6. A ceramic multilayer substrate comprising:
a laminated substrate body constituted by stacking a plurality of ceramic layers and inner conductor layers;
a land provided on a surface of the laminated substrate body, for electrical connection to external electrodes of a mounting component;
the mounting component mounted on the land via solder;
a resin sealing material for sealing the mounting component; and
a siloxane film provided so as to cover the laminated substrate body and the resin sealing material, and the siloxane film having a thickness less than 100 nm.

7. The ceramic multilayer substrate according to any one of claims 1 to 6, wherein the mounting component includes an IC component and is electrically connected to the lands by means of wire bonding.

8. The ceramic multilayer substrate according to claim 7, wherein the IC component is contained in a cavity provided on one principal surface of the laminated substrate body.

9. The ceramic multilayer substrate according to any one of claims 1 to 8, wherein a plating film is formed on the land.

10. A method of manufacturing a ceramic multilayer substrate, comprising steps of:
forming a laminated substrate body by stacking a plurality of ceramic layers and inner conductor layers;
forming land, on a surface of the laminated substrate body, for electrical connection to external electrodes of a mounting component; and
forming a siloxane film with a thickness less than 100 nm by means of a PVD process so as to cover the laminated substrate body and the land.

11. The method of manufacturing of a ceramic multilayer substrate according to claim 10, further comprising steps of:
mounting the mounting component on the lands, on which the siloxane film is formed, via solder; and
forming a siloxane film with a thickness less than 100 nm by means of a PVD process so as to cover the mounting component and at least a part of the solder.

12. A method of manufacturing of a ceramic multilayer substrate, comprising steps of:
forming a laminated substrate body by stacking a plurality of ceramic layers and inner conductor layers;
forming land, on a surface of the laminated substrate body, for electrical connection to external electrodes of a mounting component;
mounting the mounting component on the land via solder; and
forming a siloxane film with a thickness less than 100 nm by means of a PVD process so as to cover the laminated substrate body, the mounting component, and at least a part of the solder.

13. The method of manufacturing of a ceramic multilayer substrate according to one of claims 10 to 12, further comprising a step of sealing the mounting component with a sealing material, subsequent to the step of forming the siloxane film with a thickness less than 100 nm by means of the PVD process so as to cover the mounting substrate.

14. The method of manufacturing of a ceramic multilayer substrate according to claim 13, further comprising a step of forming a siloxane film with a thickness less than 100 nm by means of a PVD process so as to cover the resin sealing material.

15. A method of manufacturing of a ceramic multilayer substrate, comprising steps of:
forming a laminated substrate body by stacking a plurality of ceramic layers and inner conductor layers;
forming land on the surface of the laminated substrate body, for electrical connection to external electrodes of a mounting component;
mounting the mounting component on the land via solder;
sealing the mounting component with a sealing material; and
forming a siloxane film with a thickness less than 100 nm by means of a PVD process so as to cover the laminated substrate body and the resin sealing material.

16. A method of manufacturing of a ceramic multilayer substrate, comprising steps of:
forming a laminated substrate body by stacking a plurality of ceramic layers and inner conductor layers;
forming land on a surface of the laminated substrate body, for electrical connection to external electrodes of a mounting component;
forming solder balls on the land;
forming a siloxane film with a thickness less than 100 nm by means of a PVD process so as to cover the laminated substrate body, the land, and the solder ball;
forming another siloxane film with a thickness less tha,n 100 nm by means of the PVD process so as to cover the mounting substrate; and
mounting the mounting component on the land via the solder ball.

17. A method of manufacturing of a ceramic multilayer substrate, comprising steps of:
forming a laminated substrate body by stacking a plurality of ceramic layers and inner conductor layers;
forming land on the surface of the laminated substrate body, for electrical connection to external electrodes of a mounting component;
forming a siloxane film with a thickness less than 100 nm by means of a PVD process so as to cover the laminated substrate body and the land;
forming a solder ball on the mounting component;
forming another siloxane film with a thickness less than 100 nm by means of the PVD process so as to cover the mounting component and the solder ball; and
mounting the mounting component on the land via the solder ball.

18. The method of manufacturing of a ceramic multilayer substrate according to claim 16 or 17, further comprising a step of sealing the mounting component with a resin sealing material, subsequent to the step of mounting the mounting component.

19. The method of manufacturing of a ceramic multilayer substrate according to claim 18, further comprising a step of forming a siloxane film with a thickness less than 100 nm by means of a PVD process so as to cover the laminated substrate body and the resin sealing material.

20. The method of manufacturing of a ceramic multilayer substrate according to any one of claims 10 to 19, comprising a step of activating a surface of the siloxane film.

21. The method of manufacturing of a ceramic multilayer substrate according to claim 20, wherein the step of activating a surface of the siloxane film is performed by subjecting the surface of the siloxane film to cleaning using oxygen plasma.
